# EUROPÄISCHE PATENTSCHRIFT

(11) **EP 3 799 136 B1**
(45) Veröffentlichungstag und Bekanntmachung des Hinweises auf die Patenterteilung: **01.02.2023**
(21) Anmeldenummer: 19000434.1
(22) Anmeldetag: 27.09.2019
(51) Int. Cl.: H01L 31/0687, H01L 31/0304, H01L 31/041, H01L 31/054

(54) **MONOLITHISCHE MEHRFACHSOLARZELLE MIT GENAU VIER TEILZELLEN**
MONOLITHIC MULTI-JUNTION SOLAR CELL WITH EXACTLY FOUR SUBCELLS
CELLULE SOLAIRE MONOLITHIQUE À MULTI-JONCTIONS COMPORTANT EXACTEMENT QUATRE SOUS-CELLULES

(43) Veröffentlichungstag der Anmeldung: 31.03.2021
(73) Patentinhaber: AZUR SPACE Solar Power GmbH, 74072 Heilbronn (DE)
(72) Erfinder: Meusel, Matthias, 74076 Heilbronn (DE)
(74) Vertreter: Koch Müller Patentanwaltsgesellschaft mbH

(56) Entgegenhaltungen:
- WO-A1-2016/015467
- DE-A1-102017 200 700
- US-B1- 6 660 928
- LIU X Q ET AL: "Organometallic vapor phase epitaxy growth of upright metamorphic multijunction solar cells", JOURNAL OF CRYSTAL GROWTH, Bd. 352, Nr. 1, 9. November 2011 (2011-11-09), Seiten 186-189, XP028928586, ISSN: 0022-0248, DOI: 10.1016/J.JCRYSGRO.2011.10.024
- VAISMAN MICHELLE ET AL: "Direct-Gap 2.1-2.2 eV AlInP Solar Cells on GaInAs/GaAs Metamorphic Buffers", IEEE JOURNAL OF PHOTOVOLTAICS, I E E E, US, Bd. 6, Nr. 2, März 2016 (2016-03), Seiten 571-577, XP011600041, ISSN: 2156-3381, DOI: 10.1109/JPHOTOV.2015.2506401 [gefunden am 2016-02-18]
- VAN LEEST ET AL: "Recent Progress of Solar Cell Development for CPV Applications at Azur Space", PROC. OF THE 36TH EU PVSEC 2019, 9. September 2019 (2019-09-09), - 13. September 2019 (2019-09-13), Seiten 586-589, XP040706986, ISBN: 978-3-936338-60-7
- SHARPS P R ET AL: "Development of 20% efficient GaInAsP solar cells", PROCEEDINGS OF THE PHOTOVOLTAIC SPECIALISTS CONFERENCE. LOUISVILLE, MAY 10 - 14, 1993; [PROCEEDINGS OF THE PHOTOVOLTAIC SPECIALISTS CONFERENCE], NEW YORK, IEEE, US, Bd. CONF. 23, 10. Mai 1993 (1993-05-10), Seiten 633-638, XP010113181, DOI: 10.1109/PVSC.1993.347019 ISBN: 978-0-7803-1220-3

## Beschreibung

Die Erfindung betrifft eine monolithische metamorphe Vierfach-Solarzelle.

Die Herstellung einer Vierfach-Solarzelle mit einer Teilzelle aus GaInAsP ist aus der Druckschrift "Wafer bonded four-junction GaInP/GaAs/GaInAsP/ GaInAs concentrator solar cells with 44.7% efficiency" von Dimroth et al. in Progr. Photovolt: Res. Appl. 2014; 22: 277-282, bekannt. In der genannten Druckschrift wird ausgehend von einem InP Substrat eine GaInAsP Solarzelle mit einer Energiebandlücke von ca. 1,12 eV gitterangepasst abgeschieden.

Die oberen Teilzellen mit höherer Bandlücke werden in einer zweiten Abscheidung in invertierter Reihenfolge auf einem GaAs Substrat hergestellt. Die Bildung der gesamten Mehrfach-Solarzelle geschieht durch einen direkten Halbleiterbond der beiden Epitaxiewafer, mit einer anschließenden Entfernung des GaAs Substrates und weiteren Prozessschritten. Der Herstellungsprozess ist jedoch sehr aufwändig und kostenintensiv.

Aus EP 2 960 950 A1 und EP 3 179 521 A1 sind weitere Mehrfach-Solarzellen mit GaInAsP Teilzelle bekannt. Aus der US 5 660 928 B1 sowie der WO 2016/015467 A1 sind Ge/InGaAs/InGaAsP/AlGaInP vierfach-Solarzellen mit metamorphem Puffer bekannt.

Des Weiteren ist aus der Dissertation von Mendorf, "Ortsaufgelöste Charakterisierung von Entmischungsphänomen in GaxIn1-xAsyP1-y-Halbleiterheteroschichten im Raster-Transmissionselektronenmikroskop" bekannt, dass insbesondere die Verbindung GaInAsP eine erhebliche Mischungslücke aufweist. Hierdurch lassen sich bei GaInAsP ein großer Bereich von Gitterkonstanten und Bandlücke nicht realisieren, insbesondere bei den hohen Anforderungen an die Qualität von Schichten für die Herstellung von Hochleistungsmehrfach Solarzellen mit einem Wirkungsgrad oberhalb von 32% bei AM0, oder oberhalb von 43% bei konzentriertem Licht.

Zwar lässt sich vermuten, dass bei einer höheren Temperatur sich bei der Epitaxie die Mischungslücke etwas verringert, jedoch ist bekannt, dass bei Mehrfachzellen mit einer-Ge Unterzelle eine Ge Autodotierung auftritt. Die Autodotierung führt jedoch bei einer Erhöhung der Temperaturen bei der epitaktischen Abscheidung zu erheblichen Ausbeuteproblemen.

Die Optimierung der Strahlungshärte, insbesondere auch für sehr hohe Strahlungsdosen, ist ein wichtiges Ziel bei der Entwicklung von Raumfahrtsolarzellen. Ziel ist es neben der Steigerung des Anfangs- bzw. beglnning-of-life (BOL) Wirkungsgrades auch den end-of-life (EOL) Wirkungsgrades zu erhöhen.

Weiterhin sind die Herstellungskosten von entscheidender Bedeutung. Der industrielle Standard zum derzeitigen Zeitpunkt ist durch gitterangepasste Dreifach-Solarzellen und die metamorphe GaInP/GaInAs/Ge Dreifach-Solarzellen gegeben.

Vor diesem Hintergrund besteht die Aufgabe der Erfindung darin, eine Vorrichtung anzugeben, die den Stand der Technik weiterbildet.

Die Aufgabe wird durch eine Mehrfach-Solarzelle mit den Merkmalen des Patentanspruchs 1 gelöst. Vorteilhafte Ausgestaltungen der Erfindung sind Gegenstand von Unteransprüchen.

In dem Gegenstand wird eine monolithische Mehrfach-Solarzelle mit genau vier Teilzellen bereitgestellt.

Die Mehrfachsolarzelle weist eine oberste erste Teilzelle mit einer ersten Bandlücke Eg1 in einem Bereich zwischen 1,85 eV und 2,07 eV auf.

Unter der ersten Teilzelle ist eine darunter angeordnete zweite Teilzelle mit einer zweiten Bandlücke Eg2 im Bereich zwischen 1,41 eV und 1,53 eV angeordnet.

Unter der zweiten Teilzelle ist eine darunter angeordnete dritte Teilzelle mit einer dritten Bandlücke Eg3 im Bereich zwischen 1,04 eV und 1,18 eV ausgebildet.

Unter der dritten Teilzelle ist eine unterste vierte Tellzelle angeordnet, wobei die vierte Teilzelle aus Germanium besteht und eine Bandlücke von zwischen 0,65 eV und 0,68 eV aufweist.

Zwischen der dritten Teilzelle und der vierten Teilzelle ist ein metamorpher Puffer ausgebildet, wobei der metamorphe Puffer eine Abfolge von mindestens drei Schichten aufweist und die Gitterkonstante bei der Abfolge der Schichten in Richtung der dritten Teilzelle von Schicht zu Schicht ansteigt.

Jede der vier Teilzellen weist einen Emitter und eine Basis auf.

Die oberste erste Teilzelle weist eine Schicht aus einer Verbindung mit wenigstens den Elementen Al und In und P auf. Die Dicke der Schicht ist größer als 100 nm und als Teil des Emitters und / oder als Teil der Basis und / oder als Teil einer zwischen Emitter und Basis liegenden Raumladungszone ausgebildet. Die Gitterkonstante a1 der Schicht liegt zwischen 0,572 nm und 0,577 nm. Bezogen auf die Elemente der III-Hauptgruppe liegt der Indium-Gehalt der Schicht zwischen 64% und 75% und der Al-Gehalt der Schicht zwischen 18% und 32%.

Die dritte Teilzelle weist eine Schicht aus einer Verbindung mit wenigstens den Elementen Ga und In und As auf, wobei die Dicke der Schicht größer als 100 nm und als Teil des Emitters und / oder als Teil der Basis und / oder als Teil der zwischen Emitter und Basis liegenden Raumladungszone ausgebildet ist. Die Gitterkonstante a3 der Schicht liegt zwischen 0,572 nm und 0,577 nm und bezogen auf die Elemente der III-Hauptgruppe ist der Indium-Gehalt der Schicht größer als 17%.

Die zweite Teilzelle weist eine Schicht mit einer Verbindung mit wenigstens den Elementen Ga und In und As und P auf, wobei die Dicke der Schicht größer als 100 nm ist und die Schicht als Teil des Emitters und / oder als Teil der Basis und / oder als Teil der zwischen Emitter und Basis liegenden Raumladungszone ausgebildet ist. Bezogen auf die Elemente der V-Hauptgruppe weist die Schicht ein Arsen-Gehalt zwischen 22% und 33% und bezogen auf die Elemente der III-Hauptgruppe ein Indium-Gehalt zwischen 52% und 65% auf. Die Gitterkonstante a2 liegt zwischen 0,572 nm und 0,577 nm und unterscheidet sich von der Gitterkonstante der Schicht der dritten Teilzelle um weniger als 0,3% oder weniger als 0,2 %.

Es wird angemerkt, dass das Sonnenlicht immer zuerst durch die oberste Teilzelle mit der größten Bandlücke eingestrahlt wird. Anders ausgedrückt, der Solarzellenstapel absorbiert mit der obersten Teilzelle zuerst den kurzwelligen Anteil des Lichtes. Vorliegend durchströmen die Photonen also erst die erste Teilzelle und anschließend die zweite Teilzelle und die dritte Teilzelle und die vierte Teilzelle. In einem Ersatzschaltbild sind die einzelnen Teilzellen der Mehrfach-Solarzelle in Serie verschaltet, d.h. diejenige Teilzelle mit dem geringsten Strom wirkt limitierend.

Auch sei angemerkt, dass unter den Begriffen Emitter und Basis entweder die p-dotierten oder die n-dotierten Schichten in der jeweiligen Teilzelle verstanden werden.

Auch sei angemerkt, dass unter dem Begriff vorliegend die chemischen Abkürzungen von Elementen synonym zu den vollständigen Begriffen verwendet werden.

Untersuchungen haben überraschender Weise ergeben, dass sich GaInAsP im genannten Kompositionsbereich mittels MOVPE mit überraschend guter Qualität abscheiden lässt. Hierdurch wird das Vorurteil überwunden, dass sich GaInAsP im genannten Kompositionsbereich, der innerhalb der Mischungslücke liegt, nicht mit der für Solarzellen notwendigen Qualität abscheidbar ist.

Es versteht sich, dass insbesondere der angegebene Arsen-Gehalt auf den Gesamtgehalt der Gruppe-V Atome bezogen ist. Entsprechend ist der angegebene Indium-Gehalt auf den Gesamtgehalt der Gruppe-III Atome bezogen. D.h. bei der Verbindung Ga_{1-X}In_{X}As_{Y}P_{1-Y} beträgt der Indium-Gehalt den Wert X und der Arsen-Gehalt den Wert Y und hierdurch ergibt sich für einen Arsen-Gehalt von z.B. 25% ein Y-Wert von 0,25.

Erfindungsgemäß ist zwischen der dritten Teilzelle und der vierten Teilzelle ein Halbleiterspiegel angeordnet.

In einer anderen Weiterbildung unterscheidet sich die Gitterkonstante der Schicht der ersten Teilzelle von der Gitterkonstante der Schicht der dritten Teilzelle um weniger als 0,3% oder weniger als 0,2 %.

In einer Ausführungsform ist zwischen den vier Teilzellen kein Halbleiterbond ausgebildet. Es sei angemerkt, dass mit dem Begriff "Halbleiterbond" insbesondere umfasst ist, dass zwischen zwei beliebigen Teilzellen des Solarzellenstapels auch kein direkter Halbleiterbond ausgebildet ist. D.h. der Solarzellestapel wird nicht aus zwei Teilstapeln hergestellt, welche auf unterschiedlichen Substraten abgeschieden wurden und nachträglich über einen Halbleiterbond zusammengefügt sind. Insbesondere weist der Solarzellenstapel keine amorphen Zwischenschichten auf, wie sie beim Bonden entstehen können. In einer Weiterbildung sind bei der zweiten Teilzelle die Dicke der Schicht und bei der dritten Teilzelle die Dicke der Schicht jeweils größer als 0,4 µm oder größer als 0,8 µm.

In einer Ausführungsform liegen bei der zweiten Teilzelle der Arsen-Gehalt der Schicht zwischen 23% und 33% und der Indium-Gehalt der Schicht zwischen 52% und 63%.

In einer anderen Ausführungsform liegen bei der zweiten Teilzelle der Arsen-Gehalt der Schicht zwischen 24% und 33% und der Indium-Gehalt der Schicht zwischen 52% und 61%.

In einer Weiterbildung ist die Schicht der zweiten Teilzelle zumindest teilweise mit den Dotierstoffen Zn oder C oder Mg p-dotiert oder zumindest teilweise mit den Dotierstoffen Si oder Te oder Se n-dotiert.

In einer anderen Weiterbildung bildet die Schicht der zweiten Teilzelle sowohl einen n-dotierten Emitter als auch eine p-dotierten Basis aus.

In einer Ausführungsform steigt zumindest über einen Teil der Schicht der zweiten Teilzelle die Dotierstoffkonzentration in Richtung der dritten Teilzelle um mehr als 1×10¹⁷/cm³ an.

Erfindungsgemäß bildet zumindest ein Teil der Schicht der zweiten Teilzelle zumindest einen Teil des Emitters der zweiten Teilzelle aus und weist hier eine Dotierstoffkonzentration kleiner als 5×10¹⁷/cm³ auf.

In einer Weiterbildung ist zweite Teilzelle als sogenannte Homo-Teilzelle oder alle Teilzellen sind als Homo-Teilzellen ausgebildet, d.h. die Emitterschicht und die Basisschicht der jeweiligen Teilzelle weisen dieselbe Anzahl der Elemente in der Verbindung mit vorzugsweise derselben Stöchiometrie auf.

In einer anderen Weiterbildung ist jeweils die oberste Schicht einer Teilzelle, d.h. vorliegend die Emitterschicht als n-Schicht ausgebildet. Vorzugsweise liegt die Emitterschicht immer oberhalb der Basisschicht. Insbesondere ist in einer Weiterbildung zwischen der Emitterschicht und der Basisschicht keine intrinsische Schicht ausbildet.

In einer Weiterbildung ist oberhalb der Schicht der zweiten Teilzelle und unterhalb der ersten Teilzelle eine Passivierungsschicht aus einer Verbindung mit wenigstens den Elementen Ga und In und P angeordnet. Anders ausgedrückt die Passivierungsschicht ist zwischen der ersten Teilzelle und der zweiten Teilzelle ausgebildet.

In einer anderen Weiterbildung ist unterhalb der Schicht der zweiten Teilzelle und oberhalb des metamorphen Puffers eine Passivierungsschicht aus einer Verbindung mit wenigstens den Elementen Ga und In und P angeordnet.

In einer Ausführungsform weist die zweite Teilzelle und / oder die weiteren Teilzellen keine Vielfach-Quantentopf-Struktur auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände sowie die lateralen und die vertikalen Erstreckungen sind nicht maßstäblich und weisen, sofern nicht anders angegeben, auch keine ableitbaren geometrischen Relationen zueinander auf. Darin zeigen, die
Figur 1 einen Schichtaufbau einer ersten Ausführungsform (nicht Teil der beanspruchten Erfindung) einer Vierfachsolarzelle,
Figur 2 einen Schichtaufbau einer zweiten Ausführungsform (nicht Teil der beanspruchten Erfindung) einer Vierfachsolarzelle,
Figur 3 einen Schichtaufbau einer ersten erfindungsgemäßen Ausführungsform einer Vierfachsolarzelle,
Figur 4 einen Schichtaufbau einer zweiten erfindungsgemäßen Ausführungsform einer Vierfachsolarzelle,
Figur 5 einen Schichtaufbau einer dritten erfindungsgemäßen Ausführungsform einer Vierfachsolarzelle.

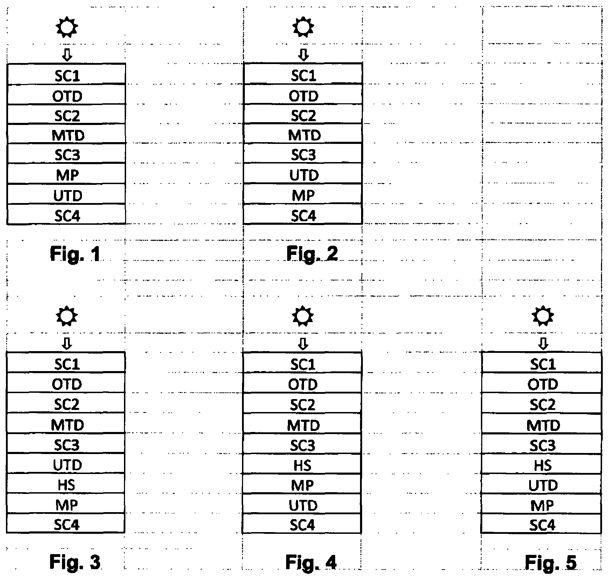

Die Abbildung der Figur 1 zeigt eine erste Ausführungsform einer Vierfachsolarzelle, die nicht Teil der beanspruchten Erfindung ist, mit einer ersten Obersten Teilzelle SC1 auf einer darunterliegenden Zwischen der ersten Teilzelle SC1 und der zweiten Teilzelle SC2 ist eine obere Tunneldiode OTD ausgebildet.

Unterhalb der zweiten Teilzelle SC2 ist eine dritte Teilzelle SC3 angeordnet. Zwischen der zweiten Teilzelle SC2 und der dritten Teilzelle SC3 ist eine mittlere Tunneldiode MTD ausgebildet.

Unterhalb der dritten Teilzelle SC3 ist eine vierte Teilzelle SC4 angeordnet. Zwischen der dritten Teilzelle SC3 und der vierten Teilzelle SC4 ist eine mittlere Tunneldiode MTD ausgebildet.

Zwischen der dritten Teilzelle SC3 und der mittleren Tunneldiode MTD ist ein metamorpher Puffer MP angeordnet.

Die Abbildung der Figur 2 zeigt eine zweite Ausführungsform einer Vierfachsolarzelle, die nicht Teil der beanspruchten Erfindung ist. Im Folgenden werden nur die Unterschiede zu der ersten Ausführungsform erläutert.

Zwischen der dritten Teilzelle SC3 und der vierten Teilzelle SC4 ist die untere Tunneldiode UTD ausgebildet, wobei der metamorphe Puffer MP nunmehr zwischen der unteren Tunneldiode UTD und vierten Teilzelle angeordnet ist.

Die Abbildung der Figur 3 zeigt eine erste erfindungsgemäße Ausführungsform einer Vierfachsolarzelle. Im Folgenden werden nur die Unterschiede zu der zweiten Ausführungsform erläutert.

Zwischen der unteren Tunneldiode UTD und dem metamorphen Puffer MP ist ein Halbleiterspiegel HS angeordnet. Anders ausgedrückt unterhalb der dritten Teilzelle SC3 ist zuerst die untere Tunneldiode UTD und anschließend der Halbleiterspiegel HS und anschließend der metamorphe Puffer MP ausgebildet bevor anschließend die unterste vierte Teilzelle SC4 ausgebildet ist.

Die Abbildung der Figur 4 zeigt eine zweite erfindungsgemäße Ausführungsform einer Vierfachsolarzelle. Im Folgenden werden nur die Unterschiede zu der dritten Ausführungsform erläutert.

Unterhalb der dritten Teilzelle SC3 ist zuerst der Halbleiterspiegel HS und anschließend der metamorphe Puffer MP und anschließend die untere Tunneldiode UTD ausgebildet, bevor anschließend die unterste vierte Teilzelle SC4 ausgebildet ist, wobei die vorgenannten Schichten in der genannten Reihenfolge angeordnet sind.

Die Abbildung der Figur 5 zeigt eine dritte erfindungsgemäße Ausführungsform einer Vierfachsolarzelle. Im Folgenden werden nur die Unterschiede zu der vierten Ausführungsform erläutert.

Unterhalb der dritten Teilzelle SC3 ist zuerst der Halbleiterspiegel HS und anschließend die untere Tunneldiode UTD und anschließend der metamorphe Puffer MP ausgebildet, bevor anschließend die unterste vierte Teilzelle SC4 ausgebildet ist, wobei die vorgenannten Schichten in der genannten Reihenfolge angeordnet sind.

## Patentansprüche

1. Monolithische Mehrfach-Solarzelle mit genau vier Teilzellen umfassend
- eine oberste erste Teilzelle (SC1) mit einer ersten Bandlücke Eg1 in einem Bereich zwischen 1,85 eV und 2,07 eV,
- eine darunter angeordnete zweite Teilzelle (SC2) mit einer zweiten Bandlücke Eg2 im Bereich zwischen 1,41 eV und 1,53 eV,
- eine darunter angeordnete dritte Teilzelle (SC3) mit einer dritten Bandlücke Eg3 im Bereich zwischen 1,04 eV und 1,18 eV,
- eine unterste vierte Teilzelle (SC4), wobei die vierte Teilzelle (SC4) aus Germanium besteht und eine Bandlücke von zwischen 0,65 eV und 0,68 eV aufweist,
- ein zwischen der dritten Teilzelle (SC3) und der vierten Teilzelle (SC4) ausgebildeten metamorphen Puffer (MP1), wobei der metamorphe Puffer (MP1) eine Abfolge von mindestens drei Schichten aufweist und die Gitterkonstante bei der Abfolge der Schichten in Richtung der dritten Teilzelle (SC3) von Schicht zu Schicht ansteigt, und
jede der vier Teilzellen (SC1, SC2, SC3, SC4) einen Emitter und eine Basis aufweist, und
die oberste erste Teilzelle (SC1) eine Schicht aus einer Verbindung mit wenigstens den Elementen Al und In und P aufweist und die Dicke der Schicht größer als 100 nm ist und die Schicht als Teil des Emitters und / oder als Teil der Basis und / oder als Teil einer zwischen Emitter und Basis liegenden Raumladungszone ausgebildet ist, und die Gitterkonstante a1 der Schicht zwischen 0,572 nm und 0,577 nm beträgt und bezogen auf die Elemente der III-Hauptgruppe der Indium-Gehalt der Schicht zwischen 64% und 75% und der Al-Gehalt der Schicht zwischen 18% und 32% liegt,
- die dritte Teilzelle (SC3) eine Schicht aus einer Verbindung mit wenigstens den Elementen Ga und In und As aufweist und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und die Gitterkonstante a3 der Schicht zwischen 0,572 nm und 0,577 nm liegt und bezogen auf die Elemente der III-Hauptgruppe der Indium-Gehalt der Schicht größer als 17% beträgt,
- die zweite Teilzelle (SC2) eine Schicht mit einer Verbindung mit wenigstens den Elementen Ga und In und As und P umfasst,
- bei der zweiten Teilzelle (SC2) die Dicke der Schicht größer als 100 nm ist und die Schicht als Teil des Emitters und / oder als Teil der Basis und / oder als Teil der zwischen Emitter und Basis liegenden Raumladungszone ausgebildet ist, wobei die Schicht bezogen auf die Elemente der V-Hauptgruppe der Arsen-Gehalt zwischen 22% und 33% und bezogen auf die Elemente der III-Hauptgruppe der Indium-Gehalt der zwischen 52% und 65% aufweist,
- die Gitterkonstante a2 zwischen 0,572 nm und 0,577 nm liegt und sich die Gitterkonstante a2 von der Gitterkonstante der Schicht der dritten Teilzelle (SC3) um weniger als 0,3% oder weniger als 0,2 % unterscheidet,
- ein Halbleiterspiegel (HS) zwischen der dritten Teilzelle (SC3) und der vierten Teilzelle (SC4) angeordnet ist,
- zumindest ein Teil der Schicht der zweiten Teilzelle (SC2) zumindest ein Teil des Emitters der zweiten Teilzelle (SC2) bildet und hier eine Dotierstoffkonzentration kleiner als 5×10¹⁷/cm³ aufweist.

2. Mehrfach-Solarzelle nach Anspruch 1, **dadurch gekennzeichnet, dass** sich die Gitterkonstante der Schicht der ersten Teilzelle (SC1) von der Gitterkonstante der Schicht der dritten Teilzelle (SC3) um weniger als 0,3% oder weniger als 0,2 % unterscheidet.

3. Mehrfach-Solarzelle nach Anspruch 1 oder Anspruch 2 **dadurch gekennzeichnet, dass** zwischen den vier Teilzellen (SC1, SC2, SC3, SC4) jeweils kein Halbleiterbond ausgebildet ist.

4. Mehrfach-Solarzelle nach einem der vorangegangenen Ansprüche, **dadurch gekennzeichnet, dass** bei der zweiten Teilzelle (SC2) die Dicke der Schicht und bei der dritten Teilzelle (SC3) die Dicke der Schicht jeweils größer als 0,4 µm oder größer als 0,8 µm sind.

5. Mehrfach-Solarzelle nach einem der vorangegangenen Ansprüche **dadurch gekennzeichnet, dass** bei der zweiten Teilzelle (SC2) der Arsen-Gehalt der Schicht zwischen 24% und 33% liegt und der Indium-Gehalt der Schicht zwischen 52% und 61% liegt.

6. Mehrfach-Solarzelle nach einem der vorangegangenen Ansprüche **dadurch gekennzeichnet, dass** die Schicht der zweiten Teilzelle (SC2) zumindest teilweise mit den Dotierstoffen Zn oder C oder Mg p-dotiert ist oder zumindest teilweise mit den Dotierstoffen Si oder Te oder Se n-dotiert ist.

7. Mehrfach-Solarzelle nach einem der vorangegangenen Ansprüche **dadurch gekennzeichnet, dass** die Schicht der zweiten Teilzelle (SC2) sowohl einen n-dotierten Emitter als auch einen p-dotierten Basis ausbildet.

8. Mehrfach-Solarzelle nach einem der vorangegangenen Ansprüche **dadurch gekennzeichnet, dass** zumindest über einen Teil der Schicht der zweiten Teilzelle (SC2) die Dotierstoffkonzentration in Richtung der dritten Tellzelle (SC3) um mehr als 1×10¹⁷/cm³ ansteigt.

9. Mehrfach-Solarzelle nach einem der vorangegangenen Ansprüche **dadurch gekennzeichnet, dass** oberhalb der Schicht der zweiten Teilzelle (SC2) und unterhalb der ersten Teilzelle (SC1) eine Passivierungsschicht aus einer Verbindung mit wenigstens den Elementen Ga und In und P angeordnet ist.

10. Mehrfach-Solarzelle nach einem der vorangegangenen Ansprüche **dadurch gekennzeichnet, dass** unterhalb der Schicht der zweiten Teilzelle (SC2) und oberhalb des metamorphen Puffers (MP) eine Passivierungsschicht aus einer Verbindung mit wenigstens den Elementen Ga und In und P angeordnet ist.

11. Mehrfach-Solarzelle nach einem der vorangegangenen Ansprüche, **dadurch gekennzeichnet, dass** die zweite Teilzelle (SC2) keine Vielfach-Quantentopf-Struktur aufweist.

## Claims

1. Monolithic multiple solar cell with exactly four part cells, comprising
- an uppermost first part cell (SC1) with a first band gap Eg1 in a range between 1.85 eV and 2.07 eV,
- a second part cell (SC2), which is arranged thereunder, with a second band gap Eg2 in the range between 1.41 eV and 1.53 eV,
- a third part cell (SC3), which is arranged thereunder, with a third band gap Eg3 in the range between 1.05 eV and 1.18 eV,
- a lowermost fourth part cell (SC4), wherein the fourth part cell (SC4) consists of germanium and has a band gap of between 0.65 eV and 0.68 eV,
- an metamorphic buffer (MP1) formed between the first part cell (SC3) and the fourth part cell (SC4), wherein the metamorphic buffer (MP1) comprises a sequence of at least three layers and the lattice constant increases from layer to layer in the sequence of layers in the direction of the third part cell (SC3), and
each of the four part cells (SC1, SC2, SC3, SC4) comprises an emitter and a base, and the uppermost first part cell (SC1) comprises a layer of a compound with at least the elements Al and In and P and the thickness of the layer is greater than 100 nm and the layer is formed as part of the emitter and/or as part of the base and/or as part of a spatial charge zone lying between emitter and base, and the lattice constant a1 of the layer is between 0.572 nm and 0.577 nm, and referred to the elements of the III main group, the indium content of the layer lies between 64% and 75% and the Al content of the layer lies between 18% and 32%,
- the third part cell (SC3) comprises a layer of a compound with at least the elements Ga and In and As and the thickness of the layer is greater than 100 nm and the layer is formed as part of the emitter and/or as part of the base and/or as part of the spatial charge zone lying between emitter and base, and the lattice constant a3 of the layer lies between 0.572 nm and 0.577 nm and, referred to the elements of the III main group, the indium content of the layer is greater than 17%,
- the second part cell (SC2) comprises a layer with a compound with at least the elements Ga and In and As and P,
- in the second part cell (SC2) the thickness of the layer is greater than 100 nm and the layer is formed as part of the emitter and/or as part of the base and/or as part of the spatial charge zone lying between emitter and base, wherein the layer, referred to the elements of the V main group, has an arsenic content between 22% and 33% and, referred to the elements of the III main group, has an indium content between 52% and 65%,
- the lattice constant a2 lies between 0.572 nm and 0.577 nm and the lattice constant a2 differs from the lattice constant of the layer of the third part cell (SC3) by less than 0.3% or less than 0.2%,
- a semiconductor mirror (HS) is arranged between the third part cell (SC3) and the fourth part cell (SC4),
- at least a part of the layer of the second part cell (SC2) forms at least a part of the emitter of the second part cell (SC2) and here has a doping substance concentration less than 5 × 10¹⁷ / cm³.

2. Multiple solar cell according to claim 1, **characterised in that** the lattice constant of the layer of the first part cell (SC1) differs from the lattice constant of the layer of the third part cell (SC3) by less than 0.3% or less than 0.2%.

3. Multiple solar cell according to claim 1 or claim 2, **characterised in that** no semiconductor bond is formed in each instance between the four part cells (SC1, SC2, SC3, SC4).

4. Multiple solar cell according to any one of the preceding claims, **characterised in that** in the second part cell (SC2) the thickness of the layer and in the third part cell (SC3) the thickness of the layer are each greater than 0.4 µm or greater than 0.8 µm.

5. Multiple solar cell according to any one of the preceding claims, **characterised in that** in the second part cell (SC2) the arsenic content of the layer lies between 24% and 33% and the indium content of the layer lies between 52% and 61%.

6. Multiple solar cell according to any one of the preceding claims, **characterised in that** the layer of the second part cell (SC2) is at least partly p-doped with the doping substance Zn or C or Mg or is at least partly n-doped with the doping substance Si or Te or Se.

7. Multiple solar cell according to any one of the preceding claims, **characterised in that** the layer of the second part cell (SC2) forms not only an n-doped emitter, but also a p-doped base.

8. Multiple solar cell according to any one of the preceding claims, **characterised in that** the doping substance concentration increases by more than 1 × 10¹⁷ / cm³ in the direction of the third part cell (SC3) at least over a part of the layer of the second part cell (SC2).

9. Multiple solar cell according to any one of the preceding claims, **characterised in that** a passivation layer of a compound with at least the elements Ga and In and P is arranged above the layer of the second part cell (SC2) and below the first part cell (SC1).

10. Multiple solar cell according to any one of the preceding claims, **characterised in that** a passivation layer of a compound with at least the elements Ga and In and P is arranged below the layer of the second part cell (SC2) and above the metamorphic buffer (MP).

11. Multiple solar cell according to any one of the preceding claims, **characterised in that** the second part cell (SC2) does not have a multiple quantum well structure.

## Revendications

1. Cellule solaire à jonctions multiples monolithique avec exactement quatre sous-cellules comprenant
- une première sous-cellule supérieure (SC1) avec une première bande interdite Eg1 sur une plage de 1,85 eV à 2,07 eV,
- une deuxième sous-cellule (SC2) disposée au-dessous avec une deuxième bande interdite Eg2 sur une plage de 1,41 eV à 1,53 eV,
- une troisième sous-cellule (SC3) disposée au-dessous avec une troisième bande interdite Eg3 sur une plage de 1,04 eV à 1,18 eV,
- une quatrième sous-cellule inférieure (SC4), laquelle quatrième sous-cellule (SC4) est constituée de germanium et présente une bande interdite de 0,65 eV à 0,68 eV et
- un tampon métamorphique (MP1) formé entre la troisième sous-cellule (SC3) et la quatrième sous-cellule (SC4), dans laquelle le tampon métamorphique (MP1) comporte une succession d'au moins trois couches et la constante de réseau des couches augmente de couche en couche en direction de la troisième sous-cellule (SC3), et
chacune des quatre sous-couches (SC1, SC2, SC3, SC4) comporte un émetteur et une base, et
la première sous-cellule supérieure (SC1) comporte une couche faite d'un composé avec au moins les éléments A1 et In et P et l'épaisseur de cette couche est supérieure à 100 nm et cette couche est configurée comme faisant partie de l'émetteur et/ou partie de la base et/ou partie d'une zone de charge d'espace située entre l'émetteur et la base, et la constante a1 de cette couche est située entre 0,572 nm et 0,577 nm et, en ce qui concerne les éléments du groupe III, la teneur en indium de la couche est de 64 % à 75 % et la teneur en Al de la couche de 18 % à 32 %,
la troisième sous-cellule (SC3) comporte une couche faite d'un composé avec au moins les éléments Ga et In et As et l'épaisseur de cette couche est supérieure à 100 nm et cette couche est configurée comme faisant partie de l'émetteur et/ou partie de la base et/ou partie de la zone de charge d'espace située entre l'émetteur et la base, et la constante a3 de cette couche est située entre 0,572 nm et 0,577 nm et, en ce qui concerne les éléments du groupe III, la teneur en indium de la couche est supérieure à 17 %,
la deuxième sous-cellule (SC2) comporte une couche faite d'un composé avec au moins les éléments Ga et In et As et P,
- l'épaisseur de la deuxième couche est supérieure à 100 nm et cette couche est configurée comme faisant partie de l'émetteur et/ou partie de la base et/ou partie de la zone de charge d'espace située entre l'émetteur et la base, la couche présentant, en ce qui concerne les éléments du groupe V, une teneur en arsenic de 22 % à 33 % et, en ce qui concerne les éléments du groupe III, une teneur en indium de 52 % à 65 %,
- la constante de réseau a2 est située entre 0,572 nm et 0,577 nm, cette constante de réseau a2 se différenciant de la constante de réseau de la couche de la troisième sous-cellule (SC3) de moins de 0,3 % ou de moins de 0,2 %,
- un miroir semi-conducteur (HS) est formé entre la troisième sous-cellule (SC3) et la quatrième sous-cellule (SC4) et
- au moins une partie de la couche de la deuxième sous-cellule (SC2) forme au moins une partie de l'émetteur de la deuxième sous-cellule (SC2) et présente ici une concentration d'agent de dopage inférieure à 5 × 10¹⁷/cm³.

2. Cellule solaire à jonctions multiples selon la revendication 1, **caractérisée en ce que** la constante de réseau de la couche de la première sous-cellule (SC1) se différencie de la constante de réseau de la couche de la troisième sous-cellule (SC3) de moins de 0,3 % ou de moins de 0,2 %.

3. Cellule solaire à jonctions multiples selon la revendication 1 ou la revendication, **caractérisée en ce qu'**aucune liaison semi-conductrice n'est formée entre les quatre sous-cellules (SC1, SC2, SC3, SC4).

4. Cellule solaire à jonctions multiples selon une des revendications précédentes, **caractérisée en ce que**, pour la deuxième sous-cellule (SC2) et pour la troisième sous-cellule (SC3), l'épaisseur de la couche est respectivement supérieure à 0,4 µm et supérieure à 0,8 µm

5. Cellule solaire à jonctions multiples selon une des revendications précédentes, **caractérisée en ce que**, pour la deuxième sous-cellule (SC2), la teneur en arsenic de la couche est située entre 24 % et 33 % et la teneur en indium de la couche est située entre 52 % et 61 %.

6. Cellule solaire à jonctions multiples selon une des revendications précédentes, **caractérisée en ce que** la couche de la deuxième sous-cellule (SC2) est au moins partiellement dopée p avec les agents de dopage Zn ou C ou Mg ou est au moins partiellement dopée n avec les agents de dopage Si ou Te ou Se.

7. Cellule solaire à jonctions multiples selon une des revendications précédentes, **caractérisée en ce que** la couche de la deuxième sous-cellule (SC2) forme aussi bien un émetteur dopé n qu'une base dopée p.

8. Cellule solaire à jonctions multiples selon une des revendications précédentes, **caractérisée en ce qu'**au moins sur une partie de la couche de la deuxième sous-cellule (SC2), la concentration d'agent de dopage augmente en direction de la troisième sous-cellule (SC3) de plus de 1 × 10¹⁷/cm³.

9. Cellule solaire à jonctions multiples selon une des revendications précédentes, **caractérisée en ce qu'**au-dessus de la couche de la deuxième sous-cellule (SC2) et au-dessous de la première sous-cellule (SC1), une couche de passivation faite d'un composé avec au moins les éléments Ga et In et P est disposée.

10. Cellule solaire à jonctions multiples selon une des revendications précédentes, **caractérisée en ce qu'**au-dessous de la couche de la deuxième sous-cellule (SC2) et au-dessus du tampon métamorphique (MP), est disposée une couche de passivation faite d'un composé avec au moins les éléments Ga et In et P.

11. Cellule solaire à jonctions multiples selon une des revendications précédentes, **caractérisée en ce que** la deuxième sous-cellule (SC2) ne présente pas une structure à puits quantiques multiples.
